# EUROPEAN PATENT SPECIFICATION

(11) **EP 4 189 410 B1**
(45) Date of publication and mention of the grant of the patent: **04.03.2026**
(21) Application number: 21851324.0
(22) Date of filing: 26.07.2021
(51) Int. Cl.: G01R 31/333, G01R 31/327

(54) **SYSTEM AND METHOD FOR ANALYSING OUT-OF-SERVICE CIRCUIT BREAKERS WITH WIRELESS COMMUNICATION OF TIME-CRITICAL DATA**
SYSTEM UND VERFAHREN ZUR ANALYSE VON AUSSERBETRIEBLICHEN SCHUTZSCHALTERN MIT DRAHTLOSER KOMMUNIKATION VON ZEITKRITISCHEN DATEN
SYSTÈME ET PROCÉDÉ D'ANALYSE DE DISJONCTEURS HORS SERVICE AVEC UNE COMMUNICATION SANS FIL DE DONNÉES CRITIQUES DANS LE TEMPS

(30) Priority: 27.07.2020 SE 2050923
(43) Date of publication of application: 07.06.2023
(73) Proprietor: Megger Sweden Ab, 182 17 Danderyd (SE)
(72) Inventor: RUDHOLM, Stig, 762 96 Rånäs (SE)
(74) Representative: Bergenstråhle & Partners AB
(86) International application number: PCT/SE2021/050749
(87) International publication number: WO 2022/025813

(56) References cited:
- WO-A1-2019/161929
- CN-A- 102 170 174
- CN-B- 104 049 227
- DE-A1- 102018 101 639
- DE-A1- 102018 101 639
- US-A1- 2004 189 319
- US-A1- 2006 176 630
- KNEZEV MAJA ET AL: "Automated Circuit Breaker Monitoring", 1 June 2007 (2007-06-01), pages 1 - 6, XP093110159, Retrieved from the Internet <URL:https://ieeexplore.ieee.org/stampPDF/getPDF.jsp?tp=&arnumber=4275650&ref=aHR0cHM6Ly9pZWVleHBsb3JlLmllZWUub3JnL2RvY3VtZW50LzQyNzU2NTA=> [retrieved on 20231207]
- COOK W E ET AL: "Automated Monitoring and Analysis of Circuit Breaker Operation", IEEE TRANSACTIONS ON POWER DELIVERY, IEEE SERVICE CENTER, NEW YORK, NY, US, vol. 20, no. 3, 1 July 2005 (2005-07-01), pages 1910 - 1918, XP011135342, ISSN: 0885-8977, DOI: 10.1109/TPWRD.2005.848466

## Description

### Technical field

The present invention relates generally to high voltage circuit breakers, and a system and a method for analysing a circuit breaker. Specifically, an analysis of the control and contact arrangement when the circuit breaker is out of service (deenergized) to determine technical health status of the circuit breaker and its control and contact arrangement.

The system for analysing the circuit breaker is comprised of one or more measuring units and a data collection unit.

### Background art

Circuit breakers are special switches which are designed for high currents. In power plants and electrical substations, circuit breakers switch operating currents and also switch overload currents in the case of failures. It is realized that circuit breakers are central to the operation of power plants and electrical substations and therefore must be tested and serviced regularly.

A specific aspect of the function of the circuit breaker is that it typically remains in its operating position for very long time since faults occur seldom. If an error occurs, the circuit breaker must operate within specification to clear the fault considering safety for people who might be in the vicinity and the integrity of the substation in which the circuit breaker is provided. Testing, often on a set schedule, aims to check that the control and contact arrangement is working correctly if a fault were to occur.

During normal operation, various types of monitoring can be performed, often called on-line monitoring, in which case several parameters can be derived and used for analysis. In contrast to this, other parameters can only be gathered while testing the circuit breaker out of operation, often called out of service. In this latter case temporary connections are made to the control and contact arrangement of the circuit breaker and connections are made to the system for analysing the circuit breaker, hereinafter referred to as the system.

Typically, to take a circuit breaker out of service, the current flow is lead through another bay in the substation and thereby stopped. The circuit breaker is then opened, and earthing connections are applied to make the circuit breaker safe to work at. To test the circuit breaker, temporary connections are made from the control and contact arrangement and connected to a system to analyse the circuit breaker.

During testing out of service the circuit breaker is typically made to operate from the system. Several parameters are gathered during the moment of operation using various types of measurement channels located in the system. Some channels are passive in the sense that they measure existing electrical and mechanical quantities, while other electrical and mechanical quantities are measured by applying a signal and measuring the response. The temporary connections and application of signals enable the system to derive necessary parameters.

A plurality of parameters is derived from the measured quantities. Such parameter may indicate whether contacts comprised in contact arrangements are opened or closed, and an analogue position of the circuit breaker contacts. A typical parameter among those is the operation time of the circuit breaker, i.e., the time to open or close it. There are several methods used in the modules of the system, where a few are described in the following patents: US 6,965,238 B2, US 2011/0084715 A1 and US 6,850,072 B1. In determining these parameters, the behaviour of each quantity at each point of time is critical. The time span is in order of magnitude the same as the time the circuit breaker operates in and the resolution in order of magnitude of microseconds. The parameters can be used to determine the status of the circuit breaker or more specifically that the electric and mechanical components make the circuit breaker operate as designed. The determination of measured quantities at specific times must be synchronized between parts of the circuit breaker.

However, a high voltage circuit breaker is usually located in an environment with high electrical fields, derived from nearby live wires, which may carry several hundred kilo volts. Therefore, the operator of a test equipment should preferably be at a safe distance from the circuit breaker itself, and also isolated from the object under test. Also, the electrical fields induce interference, which may adversely affect the measuring.

High voltage circuit breakers are of various designs, and specifically air-insulated live tank or dead-tank circuit breakers can at higher nominal voltages have large dimensions, where using a sky-lift or ladder to reach connection points is common. Systems for analysing such breakers will require substantial amounts of cables which introduce work in handling those and increase the total weight of the system.

It is known to have a system for analysing high voltage circuit breakers wherein the measurement channels are located in a test instrument on ground. Test cables are connected between the measurement channels and the test object. Different cables are needed for different applications, e.g., timing with both sides grounded and Dynamic Resistance Measurement (DRM).

Similar to a system described above, it is known to have a system for analysing high voltage circuit breakers wherein the measurement channels are located closer to the contact arrangement and communicate with the test instrument using some data protocol but connected with wires.

It is known to have a system connected to the circuit breaker when in service, on-line, and communicate to a collecting device using wireless protocol, gathering parameters from normal operation and events.

The publication "Automated Circuit Breaker Monitoring", 2007 IEEE POWER ENGINEERING SOCIETY GENERAL MEETING, by Maja Knezev et al., discloses an automated circuit breaker monitoring system to monitor a live circuit breaker's control circuit. A deployed system uses data from the control system to track the circuit breakers switching sequences and make conclusions about their performance. The publication is silent about connecting measuring means to contacts of the high voltage contact arrangement.

The publication "Automated Monitoring and Analysis of Circuit Breaker Operation", IEEE TRANSACTIONS ON POWER DELIVERY, IEEE SERVICE CENTER, by W Cook et al., discloses automated analysis of circuit breaker operation of a live circuit breaker, based on a record of waveforms taken from the circuit breaker control circuit and using advanced wavelet transforms for waveform feature extraction and an expert system for decision making. The publication is silent about connecting measuring means to contacts of the high voltage contact arrangement.

Patent publication No. CN 102 170 174 A discloses a remote operation control device for feeder circuit breaker of 6-20 kV cable distribution box. Patent publication No. CN 104 049 227 B discloses continuous calibration of circuit breaker trip units and metering devices. Patent publication No. DE 10 2018 101639 A1 discloses a device for signal testing at a circuit breaker.

### Summary of invention

An object of the present invention is to provide a system for analysing circuit breakers which is time saving, easier and faster to hook-up. Another object is to provide increased safety against induced or capacitively coupled voltages and operational mistakes. Still another object is to provide a system wherein measuring errors caused by the same phenomena are reduced.

The invention is based on the insight that a traditional system can be split into into modules, where the measuring devices can be placed directly at the high voltage contacts without the need for cables to a main unit. Due to the specific and demanding requirement on accuracy in time synchronization, or alignment in time, it is not easily understood that this is possible setup for a system with this application.

According to a first aspect of the invention, there is provided a method of analysing an out of service circuit breaker according to claim 1.

One enabling factor of the invention is the procedure that handles synchronization, alignment in time, of the modules involved.

In a preferred embodiment, the method comprises the additional step of, after the step of analysing the measurement data, in case a fault is discovered, taking actions to repair or replace the contact arrangement.

In a preferred embodiment, the method comprises the additional step of connecting the data collection unit to the control interface.

In a preferred embodiment, the step of establishing a common time reference for the measuring unit and the data collection unit comprises the following: determining a measurement system time in the data collection unit, and communicating a packet from the data collection unit to the measurement unit.

In a preferred embodiment, the time synchronization between the measuring unit and the data collection unit is within the order of magnitude of microseconds, more specifically within 100 microseconds, even more preferably within 25 microseconds.

In a preferred embodiment, drift of individual clocks during the measurement is compensated by continuous synchronization.

In a preferred embodiment, the step of establishing a common time reference for the measuring unit and the data collection unit comprises setting up a communication between the measuring unit and the data collection unit, preferably using an automated pairing procedure is used, preferably through a Wi-Fi Protected Setup (WPS) procedure.

In a preferred embodiment, collecting measurement data is started at a configurable time before a trig.

According to a second aspect of the invention, a system for analysing an out of service circuit according to claim 9 is provided.

As a result of the wireless communication, the inventive system has less weight than prior art systems, since the weight of cables could constitute about half of the total weight of a test system, which makes it easier to carry and transport. Also, by avoiding measurement cables, safety for operating personnel is increased. The cost of cables is considerable in test systems for circuit breakers, so reducing the number of cables would also reduce cost for the whole test system.

The modularity of the system will make the solution more flexible in the sense that more measurement channels easily can be added.

In a preferred embodiment of the system, the measuring unit determines the operating time: open, close, or a sequence of those, of the circuit breaker.

In a preferred embodiment of the system, measuring cables are provided interconnecting the contact arrangements of the circuit breaker and the measuring unit.

In a preferred embodiment of the system, the measuring unit comprises a measuring block adapted to process signals representing parameters of the contact arrangements, such as voltage and current, into measurement data for subsequent wireless transfer.

In a preferred embodiment of the system, the first and second wireless communication units are adapted to communicate measurement data by means of a protocol including messaging for synchronization of clocks in the measuring unit and the data collection unit.

In a preferred embodiment of the system, the measuring unit is adapted to operate with an adjustable timer, adapted to be adjusted through timestamped messages.

In a preferred embodiment of the system, a plurality of measuring units is provided, the plurality of measuring units preferably being adapted to communicate with a single data collection unit.

### Brief description of the drawings

The invention is now described, by way of example, with reference to the accompanying drawings, in which:
Fig. 1 is an overall view of a circuit breaker with a connected system for analysing a circuit breaker according to the invention connected thereto.
Fig. 2 is a block diagram of a measuring unit comprised in the system shown in Fig. 1.
Fig. 3 is a block diagram of a data collecting unit in the system shown in Fig. 1.
Fig. 4 is a diagram showing key characteristic of time synchronization between a measuring unit and a data collecting unit.
Fig. 5 is showing a setup of a circuit breaker, similar to Fig. 1, but with another type of circuit breaker.

### Description of embodiments

In the following, a detailed description of a system for analysing a circuit breaker according to the invention will be given.

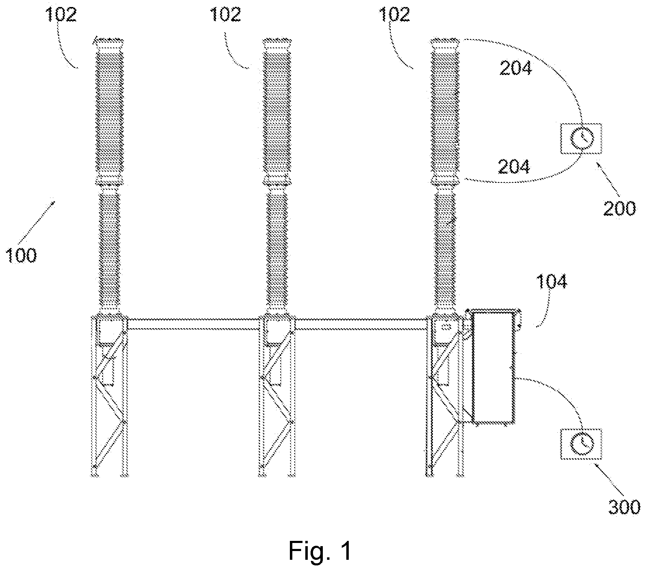

Fig. 1 is a schematic illustration of a high voltage circuit breaker, generally designated 100, comprising three phases with one contact break per phase , each considered to be the contact arrangement. It will be appreciated that the scale and design of the circuit breaker 100 varies by type and has a typical height of several meter. The figure shows a common type, as the principle of design is the same for all typical circuit breakers. However, the number of contact arrangements may vary, such as six or twelve contact breaks.

The figure illustrates a so called one-break circuit breaker with three phases 102. In general, each contact arrangement of a high voltage circuit breaker phase may include a pre-insertion resistor and a moving resistor contact electrically coupled in parallel with a moving main contact or serially with one or several moving main contacts (dead tank breakers) (not shown). Each of the contacts comprises a movable portion and a non-movable portion. The operation of the circuit breaker 100 is typically controlled through an operating mechanism with a control interface 104 provided on ground level. The control interface 104 is provided with a plurality of connectors (not shown) adapted to receive control signals from a control system or unit.

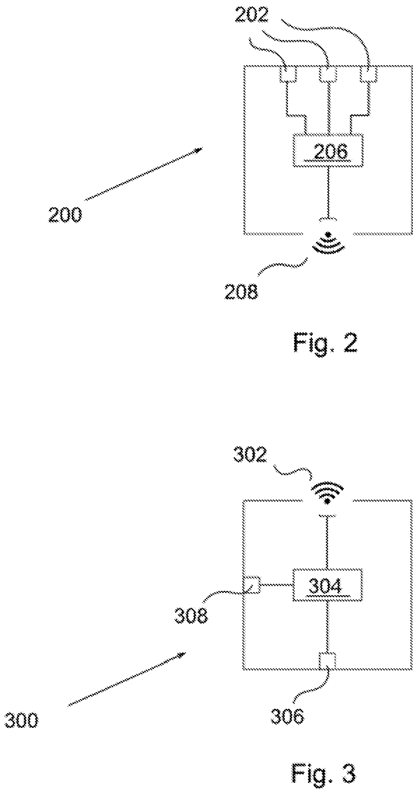

With the circuit breaker out of service, in order to measure parameters during operation of the circuit breaker, one or several measuring units 200 are connected to a respective contact arrangement of the circuit breaker. Each measuring unit 200 comprises a plurality of combined inputs and outputs 202 for measurement signals, see Fig. 2. Short measuring cables 204 interconnect the contact arrangements 102 of the circuit breaker 100 and the measuring unit 200. Internally, the inputs 202 of the measuring unit 200 are connected to a measuring block 206 comprising electronic components and circuits adapted to process the measurements signals received from the circuit breaker. More specifically, the measuring block 206 is adapted to process signals representing the parameters of the contact arrangements 102, such as voltage and current, which are input to the measuring unit 200 by means of the cables 204, into measurement data for subsequent wireless transfer. The measuring block 206 is connected to a wireless communication unit 208 in the measuring unit 200. By means of this wireless communication unit 208, measurement data can be communicated wirelessly to another unit, as will be described below.

The measuring unit 200 operates with an adjustable timer, adapted to be adjusted through timestamped messages.

The measuring unit 200 is preferably powered by an internal battery (not shown), preferably a rechargeable battery.

In preparation for testing the circuit breaker 100, the measuring unit 200 is temporarily placed as close as possible to the contact arrangements 102 to be tested. Typically, it is placed hanging in the connecting cables or on a strain-relief tied to the circuit breaker 100. By means of having the measuring unit at safe distance from any operator at ground level a substantial increase in safety is achieved.

A data collection unit 300 is provided to communicate wirelessly with the measuring unit 200. To this end, the data collection unit 300 is provided with a wireless communication unit 302, see Fig. 3, which, during operation, communicates with the wireless communication unit 208 of the measuring unit 200. Internally, the wireless communication unit 302 is connected to a control and measure block 304. The data collection unit 300 is also provided with a user interface 306. The user interface 306 may be in the form of a display, a touch screen, one or more buttons, and one or more light emitting diodes (LEDs) or a combination thereof.

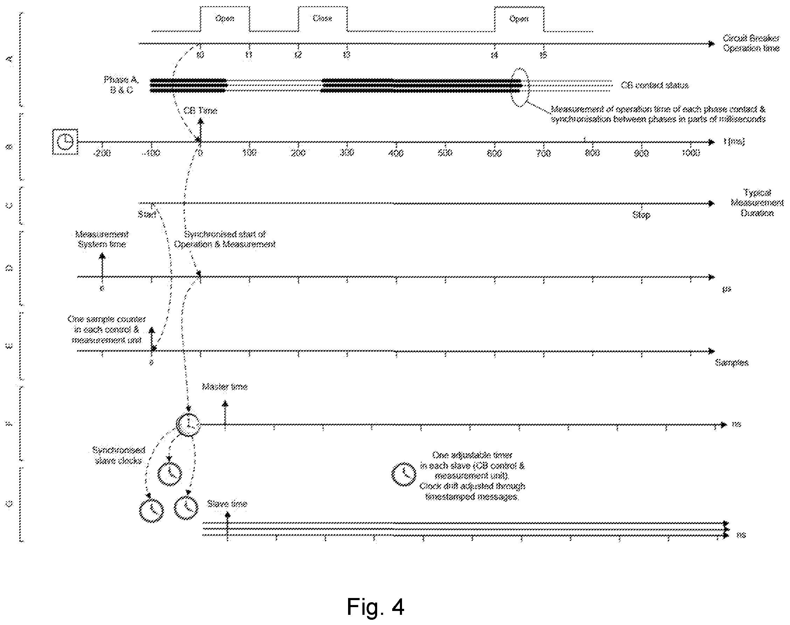

The wireless communication between units 208, 302 will now be described. Considering the layered network model OSI, to achieve stable communication and time synchronization considerations and adaptations are made in several of the layers, from the so-called physical layer (1) up to the application layer (7). Communication includes time stamped packets for data and packets for establishing a common time reference. The latter is critical for the time requirements described in Fig. 4. In the figure three parameters are indicated with reference to time during an operation sequence where the system makes the circuit breaker go through a sequence to Open, Close and Open again. Although the example shows this sequence, it will be appreciated that any sequence of operating the contact arrangement comprising opening and closing may be used.

When setting up a communication between a measuring unit 200 and a data collection unit 300, in one embodiment, an automated pairing procedure is used, in which the user presses a pairing button on both unit, which will then automatically connect to each other. This could be accomplished with a Wi-Fi Protected Setup (WPS) procedure.

Once communication between the modules has been established, the time synchronization starts automatically and continues through-out the measurement process. Fig. 4 provides a motivation and details the structure of this process. Brackets to the left in the figure designates various timelines from A to F. Starting from timeline A, the stepped curve indicates a trig (control pulse) to operate the contact arrangement 102, in this case to open the breaker at time t0, close it at time t2 and open again at time t4. Referencing all events to t0 (the first trig of the breaker) is a convention, but the relative reference is arbitrary. Also, the three phase lines of the circuit breaker indicate the actual physical position of the three phases of the circuit breaker. These lines are the measured, true, position of the circuit breaker's contacts. This is a typical measurement of a circuit breaker, and among those parameters calculated the alignment in time between the three phases is calculated with resolution in order of magnitude of microseconds. It is preferred that the resolution is within 100 microseconds, even more preferably within 25 microseconds. Following the dotted arrows from timeline A, the time t0 sets the reference time as indicated in timeline B. Note that measurement is started at a configurable time before the trig, in the indicated case at 100 milliseconds before time t0. During the measurement duration each module counts and refers to time each sample as indicated in timeline D. Continuing the dotted arrows down, the reference is made to the clocks in each module. Due to the accuracy requirement of the measurement, the drift of individual clocks during the measurement is compensated by continuous synchronization.

Optionally, the data collection unit 300 is provided with a circuit breaker interface 308 adapted to connect the data collection unit 300 to the control interface 104 of the circuit breaker 100. If a circuit breaker interface 308 is provided, the data collection unit issues control commands generated in the control block 304 in order to operate the contact arrangements 102 of the circuit breaker 100 to allow testing thereof. The circuit breaker interface 308 with the control and measure block 304 also measures parameters of the operating mechanism 104, which are critical for the correct operation of the circuit breaker 100.

In operation, when a circuit breaker 100 receives a command, e.g., to open from a closed position, linkages within the contact arrangement 102 cause the movable portions of contacts (not shown) to shift towards disengaging respective the non-movable portions of the contacts. During a testing sequence, movement of the movable portion of contacts preferably initiate a timer. During testing, the resistance values of contacts may be determined, in addition to the resistance value of pre-insertion resistor and the timing of circuit breaker contacts. More specifically, the resistances are measured dynamically, and the value of pre-insertion resistor is measured in a time period elapsed between the closing of resistor contact and the closing of main contact. Based on the measured resistance values, known threshold values are used to determine when main contact and resistor contact are each considered to be open and/or closed, such that the contact timing may be calculated.

During testing, signals representing the parameters of the contact arrangements 102, such as voltage and current, are input to the measuring unit 200 by means of the cables 204. These signals are processed in the measuring block 206 of the measuring unit 200 and are subsequently transferred to the data collection unit 300 as measurement data by means of the wireless interface provided by the first wireless communication unit 208 in the measuring unit 200 and the second wireless communication unit 302 provided in the data collection unit 300. Depending on the type of circuit breaker under test, one or several measuring units 200 can be used simultaneously. If a plurality of measuring units, such as three units, each connected to a separate phase, are used, this plurality of measuring units 200 can be wirelessly connected to the same data collection unit 300.

The measurement data is then analysed to determine the state of the tested circuit breaker. In case a fault is discovered, actions are taken to repair or replace the faulty circuit breaker.

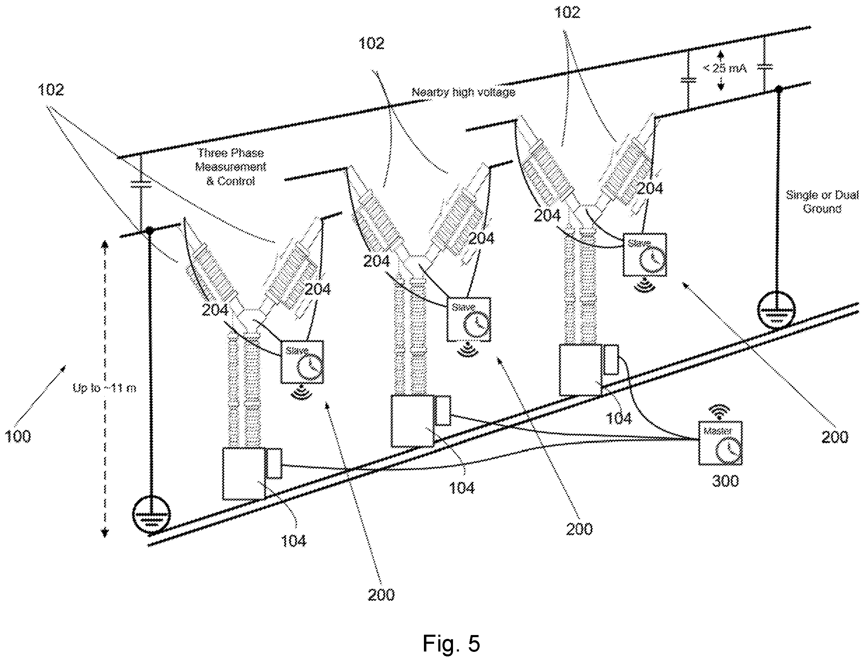

An alternative embodiment of a circuit breaker is shown in Fig. 5, wherein the same designations are used as in Fig. 1. In this figure it is shown how a single data collection unit 300, or master, wirelessly communicate with three measurement units 200, or slaves. Each measurement unit 200 is connected to a respective contact arrangement 102, each with a control interface 104.The measurements performed by the measurement units 102 can be performed either in a single or a dual ground mode. In this figure, it is indicated that voltage of nearby live high voltage affects the part of the circuit breaker that is out of service.

Preferred embodiments of a method and a system for analysing a circuit breaker, a measuring unit and a data collection unit for such a system have been described. It will be realized that these may be varied within the scope of the appended claims. Thus, the control commands for operating the contact arrangements 102 of the circuit breaker 100 to allow testing thereof may be issued by a separate control unit.

## Claims

1. A method of analysing an out of service circuit breaker (100) comprising a high voltage contact arrangement (102) and a control interface (104),
the method comprising the following steps:
- providing a data collection unit (300) for wireless communication with a measuring unit (200),
- placing the circuit breaker (100) out of service, comprising stopping the current flow, opening the circuit breaker, and applying earthing connections to make the circuit breaker safe to work at,
- temporarily connecting a measuring unit (200) to contacts of the high voltage contact arrangement of the circuit breaker for collecting measurement data,
- establishing a common time reference for the measuring unit (200) and the data collection unit (300), thereby obtaining time synchronization between the measuring unit (200) and the data collection unit (300),
- operating the high voltage contact arrangement (102), preferably comprising a sequence of opening and closing the high voltage contact arrangement, even more preferably comprising opening, closing, and opening the contact arrangement,
- collecting measurement data, such as voltage and current, from the high voltage contact arrangement by means of the measuring unit (200),
- wirelessly communicating the measurement data, preferably in time stamped packages, from the measuring unit to the data collection unit (300), and
- analysing the measurement data to determine the state of the tested circuit breaker, including the time to open or close it.

2. The method according to claim 1, comprising the additional step of:
- after the step of analysing the measurement data, in case a fault is discovered, taking actions to repair or replace the contact arrangement.

3. The method according to claim 1 or 2, comprising the additional step of:
- connecting the data collection unit (300) to the control interface (104).

4. The method according to any one of claims 1-3, wherein the step of establishing a common time reference for the measuring unit (200) and the data collection unit (300) comprises the following:
- determining a measurement system time in the data collection unit (300),
- communicating a packet from the data collection unit (300) to the measurement unit (200).

5. The method according to any one of claims 1-4, wherein the time synchronization between the measuring unit (200) and the data collection unit (300) is within the order of magnitude of microseconds, more specifically within 100 microseconds, even more preferably within 25 microseconds.

6. The method according to any one of claims 1-5, wherein drift of individual clocks during the measurement is compensated by continuous synchronization.

7. The method according to any one of claims 1-6, wherein the step of establishing a common time reference for the measuring unit (200) and the data collection unit (300) comprises setting up a communication between the measuring unit (200) and the data collection unit (300), preferably using an automated pairing procedure is used, preferably through a Wi-Fi Protected Setup (WPS) procedure.

8. The method according to any one of claims 1-7, wherein collecting measurement data is started at a configurable time before a trig.

9. A system for analysing an out of service circuit breaker (100) comprising a high voltage contact arrangement (102) and a control interface (104), the system comprising:
- a measuring unit (200) for collecting measurement data and comprising a first wireless communication unit (208), and
- a data collection unit (300) comprising a second wireless communication unit (302),
**characterized in that**
- the measuring unit (200) is adapted to be temporarily connected to contacts of the high voltage contact arrangement of the circuit breaker, and
- the first and second wireless communication units (208, 302) are adapted to communicate measurement data between the measuring unit and the data collection unit,
- wherein the first and second wireless communication units (208, 302) operate with measurement data synchronized in time in reference to a common point.

10. The system for analysing a circuit breaker (100) according to claim 9, where the measuring unit (200) determines the operating time: open, close, or a sequence of those, of the circuit breaker.

11. The system for analysing a circuit breaker (100) according to claim 9 or 10, comprising measuring cables (204) interconnecting the contact arrangements (102) of the circuit breaker (100) and the measuring unit (200).

12. The system for analysing a circuit breaker (100) according to any one of claims 9-11, wherein the measuring unit (200) comprises a measuring block (206) adapted to process signals representing parameters of the contact arrangements (102), such as voltage and current, into measurement data for subsequent wireless transfer.

13. The system for analysing a circuit breaker (100) according to any one of claims 9-12, wherein the first and second wireless communication units (208, 302) are adapted to communicate measurement data by means of a protocol including messaging for synchronization of clocks in the measuring unit (200) and the data collection unit (300).

14. The system for analysing a circuit breaker (100) according to any one of claims 9-13, wherein the measuring unit (200) is adapted to operate with an adjustable timer, adapted to be adjusted through timestamped messages.

15. The system for analysing a circuit breaker (100) according to any one of claims 9-14, comprising a plurality of measuring units (200), the plurality of measuring units (200) preferably being adapted to communicate with a single data collection unit (300).

## Patentansprüche

1. Verfahren zum Analysieren eines außer Betrieb befindlichen Leistungsschalters (100), der eine Hochspannungskontaktanordnung (102) und eine Steuerschnittstelle (104) umfasst,
wobei das Verfahren die folgenden Schritte umfasst:
- Bereitstellen einer Datenerfassungseinheit (300) für die drahtlose Kommunikation mit einer Messeinheit (200),
- Außerbetriebnahme des Leistungsschalters (100), umfassend ein Unterbrechen des Stromflusses, ein Öffnen des Leistungsschalters und ein Anbringen von Erdungsanschlüssen, um den Leistungsschalter für die Arbeit sicher zu machen,
- vorübergehendes Verbinden einer Messeinheit (200) mit Kontakten der Hochspannungskontaktanordnung des Leistungsschalters zum Erfassen von Messdaten,
- Einrichten einer gemeinsamen Zeitreferenz für die Messeinheit (200) und die Datenerfassungseinheit (300), wodurch eine Zeitsynchronisation zwischen der Messeinheit (200) und der Datenerfassungseinheit (300) erhalten wird,
- Betreiben der Hochspannungskontaktanordnung (102), vorzugsweise umfassend eine Sequenz des Öffnens und Schließens der Hochspannungskontaktanordnung, noch bevorzugter umfassend das Öffnen, Schließen und Öffnen der Kontaktanordnung,
- Erfassen von Messdaten, wie zum Beispiel Spannung und Strom, von der Hochspannungskontaktanordnung mittels der Messeinheit (200),
- drahtloses Übertragen der Messdaten, vorzugsweise in mit Zeitstempeln versehenen Paketen, von der Messeinheit zu der Datenerfassungseinheit (300), und
- Analysieren der Messdaten zum Bestimmen des Zustands des geprüften Leistungsschalters, einschließlich des Zeitpunkts zum Öffnen oder Schließen desselben.

2. Verfahren nach Anspruch 1, umfassend den zusätzlichen Schritt von:
- nach dem Schritt des Analysierens der Messdaten, falls ein Fehler entdeckt wird, Ergreifen von Maßnahmen zum Reparieren oder Ersetzen der Kontaktanordnung.

3. Verfahren nach Anspruch 1 oder 2, umfassend den zusätzlichen Schritt von:
- Verbinden der Datenerfassungseinheit (300) mit der Steuerschnittstelle (104).

4. Verfahren nach einem der Ansprüche 1 - 3, wobei der Schritt des Einrichtens einer gemeinsamen Zeitreferenz für die Messeinheit (200) und die Datenerfassungseinheit (300) das Folgende umfasst:
- Bestimmen einer Messsystemzeit in der Datenerfassungseinheit (300),
- Übertragen eines Pakets von der Datenerfassungseinheit (300) an die Messeinheit (200).

5. Verfahren nach einem der Ansprüche 1 - 4, wobei die Zeitsynchronisation zwischen der Messeinheit (200) und der Datenerfassungseinheit (300) in der Größenordnung von Mikrosekunden liegt, noch spezifischer innerhalb von 100 Mikrosekunden, noch bevorzugter innerhalb von 25 Mikrosekunden.

6. Verfahren nach einem der Ansprüche 1 - 5, wobei ein Drift einzelner Uhren während der Messung durch kontinuierliche Synchronisation kompensiert wird.

7. Verfahren nach einem der Ansprüche 1 - 6, wobei der Schritt des Einrichtens einer gemeinsamen Zeitreferenz für die Messeinheit (200) und die Datenerfassungseinheit (300) das Einrichten einer Kommunikation zwischen der Messeinheit (200) und der Datenerfassungseinheit (300) umfasst, vorzugsweise unter Verwendung eines verwendeten automatisierten Kopplungsverfahrens, vorzugsweise durch ein geschütztes Wi-Fi-Einrichtungs- (WPS) -Verfahren.

8. Verfahren nach einem der Ansprüche 1 - 7, wobei das Erfassen von Messdaten zu einem konfigurierbaren Zeitpunkt vor einem Trigger gestartet wird.

9. System zum Analysieren eines außer Betrieb befindlichen Leistungsschalters (100), der eine Hochspannungskontaktanordnung (102) und eine Steuerschnittstelle (104) umfasst, wobei das System umfasst:
- eine Messeinheit (200) zum Erfassen von Messdaten, die eine erste drahtlose Kommunikationseinheit (208) umfasst, und
- eine Datenerfassungseinheit (300), die eine zweite drahtlose Kommunikationseinheit (302) umfasst,
**dadurch gekennzeichnet, dass**
- die Messeinheit (200) so angepasst ist, dass sie vorübergehend mit Kontakten der Hochspannungskontaktanordnung des Leistungsschalters verbunden werden kann, und
- die erste und die zweite drahtlose Kommunikationseinheit (208, 302) so angepasst sind, dass sie Messdaten zwischen der Messeinheit und der Datenerfassungseinheit übertragen,
- wobei die erste und die zweite drahtlose Kommunikationseinheit (208, 302) mit zeitlich synchronisierten Messdaten in Bezug auf einen gemeinsamen Punkt arbeiten.

10. System zum Analysieren eines Leistungsschalters (100) nach Anspruch 9, wobei die Messeinheit (200) die Betriebszeit bestimmt: Öffnen, Schließen oder eine Abfolge davon des Leistungsschalters.

11. System zum Analysieren eines Leistungsschalters (100) nach Anspruch 9 oder 10, umfassend Messkabel (204), die die Kontaktanordnungen (102) des Leistungsschalters (100) und die Messeinheit (200) miteinander verbinden.

12. System zum Analysieren eines Leistungsschalters (100) nach einem der Ansprüche 9 - 11, wobei die Messeinheit (200) einen Messblock (206) umfasst, der so angepasst ist, dass er Signale, die Parameter der Kontaktanordnungen (102) darstellen, wie zum Beispiel Spannung und Strom, zu Messdaten für eine anschließende drahtlose Übertragung verarbeitet.

13. System zum Analysieren eines Leistungsschalters (100) nach einem der Ansprüche 9 - 12, wobei die erste und zweite drahtlose Kommunikationseinheit (208, 302) so angepasst sind, dass sie Messdaten mittels eines Protokolls übertragen, das Nachrichten zur Synchronisation von Uhren in der Messeinheit (200) und der Datenerfassungseinheit (300) einschließt.

14. System zum Analysieren eines Leistungsschalters (100) nach einem der Ansprüche 9 - 13, wobei die Messeinheit (200) so angepasst ist, dass sie mit einem einstellbaren Zeitgeber arbeitet, der über zeitgestempelte Nachrichten eingestellt werden kann.

15. System zum Analysieren eines Leistungsschalters (100) nach einem der Ansprüche 9 - 14, umfassend eine Vielzahl von Messeinheiten (200), wobei die Vielzahl von Messeinheiten (200) vorzugsweise so angepasst ist, dass sie mit einer einzigen Datenerfassungseinheit (300) kommunizieren.

## Revendications

1. Procédé d'analyse d'un disjoncteur (100) hors service comprenant un agencement de contact haute tension (102) et une interface de commande (104),
le procédé comprenant les étapes suivantes :
- la fourniture d'une unité (300) de collecte de données pour une communication sans fil avec une unité de mesure (200),
- la mise hors service du disjoncteur (100), comprenant l'arrêt de la circulation de courant, l'ouverture du disjoncteur et l'application de connexions de mise à la terre pour que le travail sur le disjoncteur soit sécurisé,
- la connexion provisoire d'une unité de mesure (200) à des contacts de l'agencement de contact haute tension du disjoncteur pour collecter des données de mesure,
- l'établissement d'une référence temporelle commune pour l'unité de mesure (200) et l'unité (300) de collecte de données, obtenant ainsi une synchronisation temporelle entre l'unité de mesure (200) et l'unité (300) de collecte de données,
- l'actionnement de
l'agencement de contact haute tension (102), comprenant préférablement une séquence d'ouverture et de fermeture de
l'agencement de contact haute tension, encore plus préférablement comprenant l'ouverture, la fermeture et l'ouverture de l'agencement de contact,
- la collecte de données de mesure, telles que la tension et le courant, depuis l'agencement de contact haute tension au moyen de l'unité de mesure (200),
- la communication sans fil des données de mesure, préférablement dans des paquets horodatés, de l'unité de mesure à l'unité (300) de collecte de données, et
- l'analyse des données de mesure afin de déterminer l'état du disjoncteur testé, incluant le temps de son ouverture ou de sa fermeture.

2. Procédé selon la revendication 1, comprenant l'étape supplémentaire consistant à :
- après l'étape d'analyse des données de mesure, en cas de découverte d'une défaillance, entreprendre des actions pour réparer ou remplacer l'agencement de contact.

3. Procédé selon la revendication 1 ou revendication 2, comprenant l'étape supplémentaire consistant à :
- connecter l'unité (300) de collecte de données à l'interface de commande (104).

4. Procédé selon l'une quelconque des revendications 1 à 3, dans lequel l'étape d'établissement d'une référence temporelle commune pour l'unité de mesure (200) et l'unité (300) de collecte de données comprend les actions suivantes consistant à :
- déterminer un temps de système de mesure dans l'unité (300) de collecte de données,
- communiquer un paquet de l'unité (300) de collecte de données à l'unité de mesure (200).

5. Procédé selon l'une quelconque des revendications 1 à 4, dans lequel la synchronisation temporelle entre l'unité de mesure (200) et l'unité (300) de collecte de données est de l'ordre de grandeur des microsecondes, plus spécifiquement en 100 microsecondes, encore plus préférablement en 25 microsecondes.

6. Procédé selon l'une quelconque des revendications 1 à 5, dans lequel une dérive d'horloges individuelles pendant la mesure est compensée par une synchronisation continue.

7. Procédé selon l'une quelconque des revendications 1 à 6, dans lequel l'étape d'établissement d'une référence temporelle commune pour l'unité de mesure (200) et l'unité (300) de collecte de données comprend le réglage d'une communication entre l'unité de mesure (200) et l'unité (300) de collecte de données, préférablement en utilisant une procédure d'appairage automatisée, préférablement par le biais d'une procédure de configuration Wi-Fi protégée (WPS).

8. Procédé selon l'une quelconque des revendications 1 à 7, dans lequel la collecte de données de mesure démarre à un moment configurable avant un déclenchement.

9. Système d'analyse d'un disjoncteur (100) hors service comprenant un agencement de contact haute tension (102) et une interface de commande (104), le système comprenant :
- une unité de mesure (200) destinée à collecter des données de mesure et comprenant une première unité de communication sans fil (208), et
- une unité (300) de collecte de données comprenant une seconde unité de communication sans fil (302),
**caractérisé en ce que**
- l'unité de mesure (200) est adaptée à être provisoirement connectée à des contacts de l'agencement de contact haute tension du disjoncteur, et
- les première et seconde unités de communication sans fil (208, 302) sont adaptées pour communiquer des données de mesure entre l'unité de mesure et l'unité de collecte de données,
- dans lequel les première et seconde unités de communication sans fil (208, 302) fonctionnent avec des données de mesure temporellement synchronisées en référence à un point commun.

10. Système d'analyse d'un disjoncteur (100) selon la revendication 9, dans lequel l'unité de mesure (200) détermine le moment de fonctionnement : ouverture, fermeture ou une séquence de celles-ci, du disjoncteur.

11. Système d'analyse d'un disjoncteur (100) selon la revendication 9 ou revendication 10, comprenant des câbles de mesure (204) interconnectant les agencements de contact (102) du disjoncteur (100) et l'unité de mesure (200).

12. Système d'analyse d'un disjoncteur (100) selon l'une quelconque des revendications 9 à 11, dans lequel l'unité de mesure (200) comprend un bloc de mesure (206) adapté pour traiter des signaux représentant les paramètres des agencements de contact (102), tels que la tension et le courant, en données de mesure pour un transfert sans fil ultérieur.

13. Système d'analyse d'un disjoncteur (100) selon l'une quelconque des revendications 9 à 12, dans lequel les première et seconde unités de communication sans fil (208, 302) sont adaptées pour communiquer des données de mesure au moyen d'un protocole incluant une messagerie pour synchronisation d'horloges dans l'unité de mesure (200) et l'unité (300) de collecte de données.

14. Système d'analyse d'un disjoncteur (100) selon l'une quelconque des revendications 9 à 13, dans lequel l'unité de mesure (200) est adaptée pour fonctionner avec un programmateur réglable, adapté pour être réglé par le biais de messages horodatés.

15. Système d'analyse d'un disjoncteur (100) selon l'une quelconque des revendications 9 à 14, comprenant une pluralité d'unités de mesure (200), la pluralité d'unités de mesure (200) étant préférablement adaptées pour communiquer avec une seule unité (300) de collecte de données.
